Europäisches Patentamt

(19) European Patent Office

Office européen des brevets

(11) Publication number : **0 100 454 B2**

(12) **NEW EUROPEAN PATENT SPECIFICATION**

(45) Date of publication of the new patent specification : 04.12.91 Bulletin 91/49

(51) Int. Cl.⁵ : **H01L 23/52, H01L 29/40**

(21) Application number : 83106554.5

(22) Date of filing : 05.07.83

(54) Semiconductor device having a conductive layer consisting of a high-melting point metal silicide and a method for manufacturing such a semiconductor device.

(30) Priority : 05.07.82 JP 115450/82

(43) Date of publication of application :
15.02.84 Bulletin 84/07

(45) Publication of the grant of the patent :
30.09.87 Bulletin 87/40

(45) Mention of the opposition decision :
04.12.91 Bulletin 91/49

(84) Designated Contracting States :
DE FR GB

(56) References cited :
EP-A- 0 000 317
DE-A- 2 525 482
DE-A- 3 027 954
IEEE JOURNAL OF SOLID-STATE CIRCUITS,
vol. SC-15, no. 4, August 1980, New York P.
MURARKA et al. "Refractory silicides of
titanium and tantalum for low-resistivity gates
and interconnects" * Pages 474-482

(56) References cited :
JOURNAL OF ELECTROCHEMICAL SOCIETY,
vol. 128, no. 3, March 1981, Manchester, New
Hampshire, USA S. NOWICKI et al.
"Comparison of the properties of molyb-
denum silicide films deposited by D-C magnet-
ron and RF diode co-deposition" * Pages
562-567
Technical Digest of IEDM (1979), pp. 458-461
and 462-464
Jap. Journal of Appl. Phys., 17, (1978), pp.
37-42
J. of Appl. Phys., 51, (1980, 10), pp.5380-5385
J. of Electrochemical Soc., 128, (1981, 03),
pp.562-567
J. of Vacuum Science and Technology, 17, (4),
(1980, 07/08), pp.775-792
J. of Appl. Phys. (1980), pp. 350-356

(73) Proprietor : KABUSHIKI KAISHA TOSHIBA
72, Horikawa-cho Saiwai-ku
Kawasaki-shi Kanagawa-ken (JP)

(72) Inventor : Okumura, Katsuya
609 Utsukushigaoka-Hapinas 1-4-6,
Utsukushigaoka
Midori-ku Yokohama-shi (JP)
Inventor : Kawaguchi, Tatsuzo
406 Toshiba-Tsurumi-apartment 6-25,
Toyooka-cho
Tsurumi-ku Yokohama-shi (JP)

(74) Representative : Hansen, Bernd, Dr.rer.nat. et
al
Hoffmann, Eitle & Partner Patentanwälte
Arabellastrasse 4 Postfach 81 04 20
W-8000 München 81 (DE)

EP 0 100 454 B2

## Description

The present invention relates to a semiconductor device which uses a film of a high-melting point metal silicide which is suitable as a low-resistance electrode or wiring (to be referred to as a conductive material hereinafter).

Polysilicon has widely been used as a conductive material for forming electrodes or wiring layers. However, it is very difficult to obtain a polysilicon layer having a sheet resistance of 20 $\Omega/\square$ or less even if an impurity is diffused to a high concentration (even with a film thickness of 3,000 to 4,000 Å). Meanwhile, demand for higher performance semiconductor devices is strong today. In order to achieve this, it is considered necessary to decrease the sheet resistance of an electrode material to at least 5 $\Omega/\square$ or less and preferably to about 1/10 of that of polysilicon. In an attempt to find a substance which satisfies this requirement, many studies are being made on silicide films of high-melting point metals, in particular, a molybdenum silicide film.

Molybdenum silicides having three different formulae are known: $MoSi_2$, $Mo_3Si$, and $Mo_5Si_3$. $MoSi_2$ is regarded to be most stable against heat. For this reason, it has been general practice to use a molybdenum silicide film consisting of $MoSi_2$ as an electrode material.

However, when a molybdenum silicide film having a formula of $MoSi_2$ is exposed to an oxidizing atmosphere at a high temperature such as 1,000°C, an $SiO_2$ film is formed on the surface of the molybdenum silicide film. However, anomalous oxidation locally occurs at times to form holes or cracks in the $MoSi_2$. In some cases, separation of the film is caused due to stress. Furthermore, although the reasons are not clear, the characteristics of a resultant MOS transistor change unexpectedly. Accordingly, the use of a molybdenum silicide film having a formula of $MoSi_2$ has not been necessarily suitable for the manufacture of a semiconductor device. From the article of R. S. Nowicki et al published in J. of Electrochemical Soc. Vol. 128 (1981.03) 3, p. 562-567 it is known that Molybdenum silicide films deposited by RF diode codeposition exhibit no degredation during heat-treatment when the Mo/Si ratio is ≦0,5. The properties of $MoSi_{2,8}$ have been investigated.

The present invention has been made in consideration of this and has for its object to provide a semiconductor device having a high-melting point metal DC sputtered silicide film which is stable after a high-temperature oxidizing process and which is suitable as a conductive material, and to a method for manufacturing such a semiconductor device.

In order to achieve the above object, there is provided according to the present invention a semiconductor device according to claim 1.

This invention can be more fully un understood from the following detailed description when taken in conjunction with the accompanying drawings, in which:

Fig. 1 is a sectional view showing a MOS transistor according to the present invention;

Fig. 2 is a sectional view of an apparatus for forming a high-melting point metal silicide film according to the present invention;

Fig. 3 is a graph showing the sheet resistances as a function of the value of x of $MoSi_x$ of a molybdenum silicide film according to the present invention;

Fig. 4 is a graph showing the relative probability of occurrence of anomalous oxidation as a function of the value of x of $MoSi_x$ of a molybdenum silicide film according to the present invention;

Fig. 5 is a graph showing the thermal stress as a function of the value of x of $MoSi_x$ of a molybdenum silicide film according to the present invention;

Fig. 6 is a graph showing a flat band voltage $V_{fb}$ as a function of the value of x of $MoSi_x$ of a molybdenum silicide film according to the present invention;

Fig. 7 is a graph showing a sheet resistance as a function of the value of x of $WSi_x$ of a tungsten silicide film according to the present invention; and

Fig. 8 is a graph showing thermal stress as a function of the value of x of $WSi_x$ of a tungsten silicide film according to the present invention.

In a high-melting point metal silicide having a formula $MSi_x$ (where M is a high-melting point metal), when the value of x is kept within the range of $2<x\leqq4.0$, the sheet resistance may bekept at 5 $\Omega/\square$ or less, anomalous oxidation and generation of thermal of thermal stress may be prevented, and variations in the threshold voltage of a transistor may be suppressed to the minimum. The high-melting point metal silicide as described above is suitable as a conductive material for a semiconductor device. The present invention has been established based on this finding.

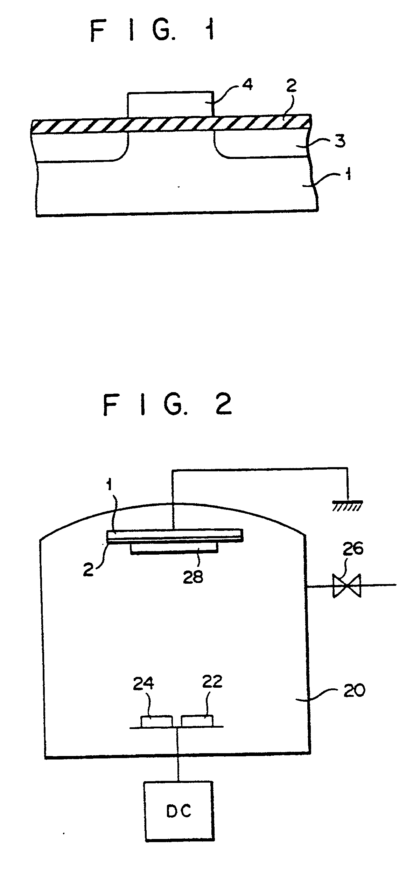

The method for forming a high-melting point metal silicide film comprising such a high-melting point metal silicide will now be described with reference to a case wherein a gate electrode of a MOS transistor as shown in Fig. 1 is formed. Fig. 1 shows a state wherein an impurity diffusion layer (source/drain region) 3 is formed in a surface layer of a semiconductor substrate 1. A gate electrode 4 comprising a high-melting point metal film such as a molybdenum silicide film is formed on the semiconductor substrate 1 through a gate insulating film 2. Fig. 2 shows the method for forming such a gate electrode 4. A semiconductor substrate 1 is first placed in a vacuum chamber 20. High-purity molybdenum 22 and silicon 24 are arranged next to each other at a distance of about 60 mm from the semiconductor substrate 1 in the vacuum chamber 20. After the vacuum chamber 20 is evacuated to about 1 x $10^{-7}$ Torr, argon gas (Ar) is introduced into the vacuum chamber 20 to a pressure of $2 \times 10^{-3}$ Torr through a variable valve 26 so as to perform DC sputtering for 3 to 4 minutes, thereby forming a molybdenum silicide film 28 on the semiconductor substrate 1 through the gate insulating film 2. The thickness of the resultant molybdenum silicide film 28 may be controlled by controlling the sputtering time. The composition of the molybdenum silicide film formed on the semiconductor substrate 1 may be freely selected by suitably changing the amounts of the molybdenum 22 and silicon 24 placed in the vacuum chamber 20. Alternatively, the composition of the molybdenum silicide film formed on the semiconductor substrate 1 may also be selected by separately controlling power applied to the molybdenum 22 and silicon 24. In the next step, annealing is performed in an oxidizing atmosphere of about 1,000°C. Annealing is performed to cause crystallization of the point metal.

In the above description, silicon and molybdenum are used as the targets and a molybdenum silicide film is formed by simultaneous sputtering using these targets.

The composition and various characteristics of the high-melting point metal silicide film formed by DC sputtering as described above will now be described. The characteristics of a film when x in the formula $MoSi_x$ of molybdenum silicide will be described below.

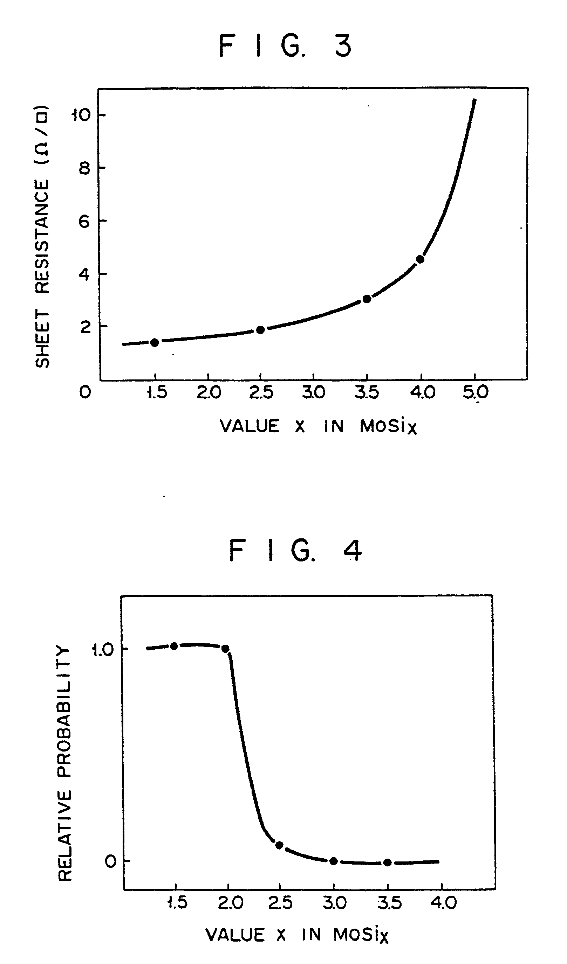

Fig. 3 shows the sheet resistance ($\Omega/\square$) as a function of the value of x of a $MoSi_x$ film having a thickness of 3,000 Å. As may be seen from the graph shown in Fig. 3, the sheet resistance increases with an increase in the amount of silicon. With recent trends for larger LSIs, the wiring layer is becoming thinner, and the resistance is increasing. Since such an increase in the resistance increases delay time through such a wiring layer, the wiring resistance must be lowered. Thus, the resistance, that is, the sheet resistance of the wiring layer is preferably small. Thus, from the graph shown in Fig. 3, when a molybdenum silicide film is to be formed, the value of x of the formula $MoSi_x$ must be about 4.0 or less so as to obtain a sheet resistance of 5 $\Omega/\square$ or less.

Fig. 4 shows the relative probability of occurrence of anomalous oxidation as a function of the value of x in the formula $MoSi_x$ when a molybdenum silicide film having this formula is oxidized at 1,000°C. It is seen from the graph shown in Fig. 4 that the relative probability significantly changes before and after x=2; the relative probability decreases abruptly when x becomes larger than 2.

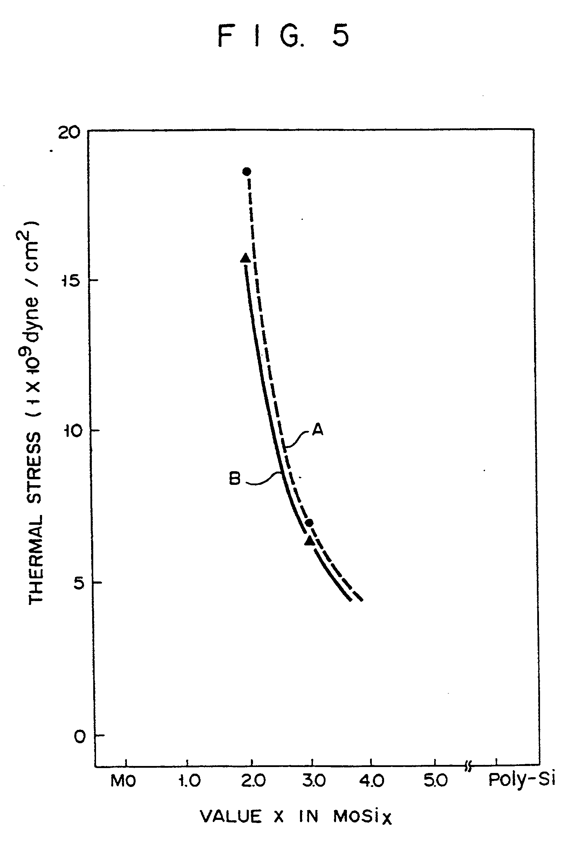

Fig. 5 shows the thermal stress as a function of the value x of the formula $MoSi_x$ of a molybdenum silicide film. Dotted curve A corresponds to a molybdenum silicide film formed by annealing in a dry $O_2$ gas atmosphere at 1,000°C for 30 minutes, and solid curve 8 corresponds to a molybdenum silicide film formed by annealing in $N_2$ gas atmosphere at 1,000°C for 30 minutes. It is seen from the graph shown in Fig. 5 that the stress abruptly decreases when the value x is 2 or more. Since the thermal stress may be decreased significantly in this manner, peeling, separation or the like of gate electrodes or capacitor electrodes formed by conventional $MoSi_x$ can be prevented. Furthermore, the effective channel length may be designed with high precision.

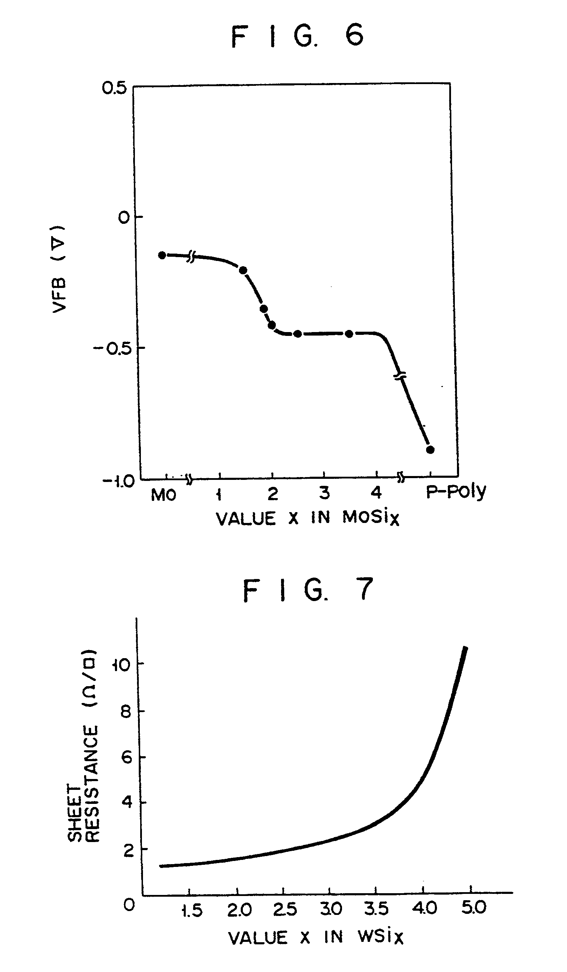

Fig. 6 shows the flat band voltage $V_{FB}$, i.e., the threshold voltage $V_{TH}$ of a transistor, as a function of the value of x of the formula $MoSi_x$ of a molybdenum silicide film. As may be seen from Fig. 6, when the value of x is within the range of $2.0 < x \leqq 4.0$, variations in the voltage $V_{FB}$ are small and stable. Accordingly, $MoSi_x$ with x falling within this range may be suitably used for a semiconductor device for channel control below a gate film of a MOS transistor or the like.

It is concluded from the measurements shown in the respective graphs described above that a molybdenum silicide having a formula $MoSi_x$ with x falling within the range of $2.0 < x \leqq 4.0$ may be suitably used for manufacturing a semiconductor device. It is also found out that a molybdenum silicide having a formula $MoSi_x$ with x falling within the range between 2.2 and 3.5 is particularly preferable for manufacturing a semiconductor device.

Although the above description has been made with reference to a case wherein molybdenum is used as a high-melting point metal, similar results were found to be obtainable with tungsten (W), tantalum (Ta), or titanium (Ti).

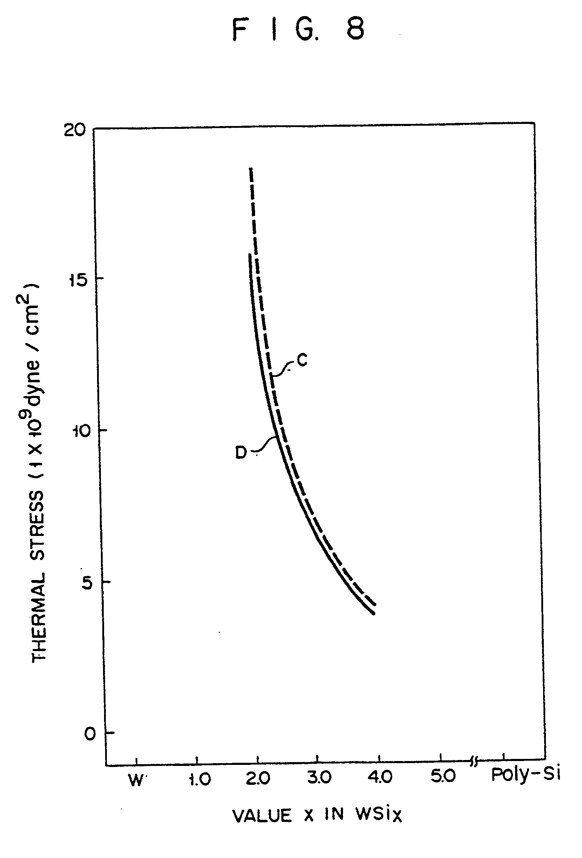

The relationship between the sheet resistance and the value of x of a formula $WSi_x$ of a tungsten silicide film and the relationship between the thermal stress and the value of x were examined. The obtained results are shown in Figs. 7 and 8. It is seen from the graphs shown in Figs. 7 and 8 that a tungsten silicide film having a formula $WSi_x$ with x falling within the range of $2.0 < x \leqq 4.0$ may be suitably used for manufacturing a semiconductor device. The experimenting conditions for obtained the results shown in Figs. 7 and 8 were the same as those for Figs. 3 and 5. Referring to Fig. 8, dotted curve C corresponds to a tungsten silicide film annealed in a dry $O_x$ gas atmosphere at 1,000°C for 30 minutes and solid curve D corresponds to a tungsten silicide film annealed in a $N_2$ gas atmosphere at 1,000°C for 30 minutes.

As can be seen from the above description, according to the present invention, a high-melting point metal silicide is used for a conductive layer. This facilitates process design since the manufacturing process for polysilicon may be used. Furthermore, the metal silicide according to the present invention has a resistance which is about 1/10 of that of polysilicon. Accordingly, when such a metal silicide is used for wiring or electrodes, a high-speed semiconductor device may be manufactured. When a high-melting point metal silicide film having the composition as defined above is used for a dynamic memory, micropatterning and low resistance for high operating speed required for a dynamic memory may be satisfied. Furthermore, the film according to the present invention may be useful as a stable conductive film even in a high-temperature oxidizing atmosphere and serves as a mask for ion-implantation. The film of the present invention thus allows self-aligned formation of an impurity diffusion region. The high-melting point metal silicide used in the present invention allows good adhesion with $SiO_2$ and may therefore be used for gate electrodes or capacitive electrodes.

According to the present invention, a high-melting Point metal M of a high-melting point metal silicide having a formula $MSi_x$ may be a combination of at least two members selected from Mo, W, Ta, and Ti.

## Claims

1. A semiconductor device which comprises a conductive layer consisting of a high-melting point metal silicide relected from molubdenum silicide, tungsten silicide, tantalum silicide and titanium silicide characterised in that the conductive layer has a formula $MSI_x$ in which M is the high-melting point metal and x is value within the range of $2.2 \leqq x \leqq 3.5$, and in that the conductive layer is a DC vacuum chamber sputtered layer subjected to annealing at a high temperature of about 1000°C in an oxidising atmosphere having a sheet resistivity of not more than $5\Omega/sq$, the device thus having a stable flat band voltage.

2. A semiconductor device according to claim 1, characterised in that the high-melting point metal silicide comprises at least two members selected from the group consisting of molybdenum silicide, tungsten silicide, titatium silicide and tantalum silicide.

3. A semiconductor device according to claim 1, characterised in that the conductive layer forms a gate electrode of a field-effect transistor.

4. A semiconductor device according to claim 1, characterised in that the conductive layer forms a capacitor electrode.

5. A semiconductor device according to claim 1, characterised in that the conductive layer forms a wiring electrode.

6. A method of manufacturing a semiconductor device as claimed in claims 1 or 2 comprising the step of depositing a high-melting point metal silicide film relected from molubdenum silicide, tungsten silicide, tantalum silicide and titanium silicide on an insulating film disposed in turn on a semiconductor substrate, characterised in that the high-melting point metal silicide film has a formula $MSi_x$ in which M is the high-melting point metal and x is a value within the range

of $2.2 \leqq x \leqq 3.5$, in that said film is DC sputtered in a vacuum chamber from separate high purity targets of said high-melting point metal and silicon and in that annealing the high-melting point metal silicide film is subsequently performed in an oxidising atmosphere at a high temperature of about 1000°C.

## Patentansprüche

1. Halbleitervorrichtung, umfassend eine leitfähige Schicht, bestehend aus einem Metallsilicid mit hohem Schmelzpunkt, ausgewählt aus Molybdänsilicid, Wolframsilicid, Tantalsilicid und Titansilicid, dadurch **gekennzeichnet** , dass die leitfähige Schicht die Formel $MSi_x$ hat, wobei M ein Metall mit hohem Schmelzpunkt und x eine Zahl im Bereich von $2,2 \leqq x \leqq 3,5$ ist, und dass die leitfähige Schicht eine DC-Vakuumkammer-Zerstäubungsschicht ist, die dem Tempern bei hoher Temperatur von etwa 1000°C in einer oxidierenden Atmosphäre ausgesetzt worden ist und einen Schichtwiderstand von nicht mehr als 5 Ohm/Quadrat hat, wobei die Vorrichtung somit eine stabile flache Bandströmung hat.

2. Halbleitervorrichtung nach Anspruch 1, dadurch **gekennzeichnet** , dass das Metallsilicid mit hohem Schmelzpunkt mindestens zwei Mitglieder aus der Gruppe aus Molybdänsilicid, Wolframsilicid, Titansilicid und Tantalsilicid umfasst.

3. Halbleitervorrichtung nach Anspruch 1, dadurch **gekennzeichnet** , dass die leitfähige Schicht eine Gate-Elektrode eines Feldeffekttransistors bildet.

4. Halbleitervorrichtung nach Anspruch 1, dadurch **gekennzeichnet** , dass die leitfähige Schicht eine Kondensatorelektrode bildet.

5. Halbleitervorrichtung nach Anspruch 1, dadurch **gekennzeichnet** , dass die leitfähige Schicht eine Verdrahtungselektrode bildet.

6. Verfahren zum Herstellen einer Halbleitervorrichtung nach Anspruch 1 oder 2, umfassend die Stufe des Abscheidens eines Metallsilicidfilmes mit hohem Schmelzpunkt, ausgewählt aus Molybdänsilicid, Wolframsilicid, Tantalsilicid und Titansilicid, auf einem Isolierfilm, der wiederum auf einem Halbleitersubstrat angeordnet ist, dadurch **gekennzeichnet** , dass der Metallsilicidfilm mit hohem Schmelzpunkt die Formel $MSi_x$ hat, wobei M das Metall mit hohem Schmelzpunkt ist und x eine Zahl im Bereich von $2,2 \leqq x \leqq 3,5$ ist, und dass der Film in einer Vakuumkammer von getrennt vorliegenden Targets hoher Reinheit dieses Metalles mit hohem Schmelzpunkt und von Silicium DC gesputtert wird, und dass der hochschmelzende Metallsilicidfilm anschliessend in einer oxidierenden Atmosphäre bei hoher Temperatur von etwa 1000°C getempert wird.

**Revendications**

1. Dispositif semiconducteur qui comprend une couche conductrice constituée d'un siliciure de métal à haut point de fusion choisi parmi le siliciure de molybdène, le siliciure de tungstène, le siliciure de tantale et le siliciure de titane, caractérisé en ce que la couche conductrice possède une formule $MSi_x$, dans laquelle M est le métal à haut point de fusion et $\underline{x}$ est une valeur comprise dans l'intervalle $2,2 \leqq x \leqq 3,5$, et en ce que la couche conductrice est une couche obtenue par pulvérisation en courant continu dans une chambre à vide, qui a été soumise à un recuit effectué à une haute température d'environ 1 000°C en atmosphère oxydante et qui présente une résistivité pelliculaire ne dépassant pas 5Ω/□, le dispositif possédant ainsi une tension de bande plate stable.

2. Dispositif semiconducteur selon la revendication 1, caractérisé en ce que le siliciure de métal à haut point de fusion comprend au moins deux éléments choisis dans le groupe formé par le siliciure de molybdène, le siliciure de tungstène, le siliciure de titane et le siliciure de tantale.

3. Dispositif semiconducteur selon la revendication 1, caractérisé en ce que la couche conductrice forme une électrode de grille d'un transistor à effet de champ.

4. Dispositif semiconductor selon la revendication 1, caractérisé en ce que la couche conductrice forme une électrode de condensateur.

5. Dispositif semiconducteur selon la revendication 1, caractérisé en ce que la couche conductrice forme une électrode de câblage.

6. Procédé de fabrication d'un dispositif semiconducteur selon la revendication 1 ou 2, comprenant l'opération qui consiste à faire déposer une pellicule de siliciure de métal à haut point de fusion, choisi parmi le siliciure de molybdène, le siliciure de tungstène, le siliciure de tantale et le siliciure de titane, sur une pellicule isolante disposée elle-même sur un substrat semiconducteur, caractérisé en ce que la pellicule de siliciure de métal à haut point de fusion possède une formule $MSi_x$, dans laquele M est le métal à haut point de fusion et $\underline{x}$ est une valeur comprise dans l'intervalle $2,2 \leqq x \leqq 3,5$, en ce que ladite pellicule est formée par pulvérisation en courant continu dans une chambre à vide partir de sources distinctes à pureté élevée dudit métal à haut point de fusion et de silicium, et en ce qu'on effectue ensuite un recuit de la pellicule de siliciure de métal à haut point de fusion, à une haute température d'environ 1 000°C en atmosphère oxydante.

# F I G. 1

# F I G. 2

# F I G. 3

# F I G. 4

# F I G. 5

# F I G. 6

VFB (∇)

VALUE X IN MoSix

# F I G. 7

SHEET RESISTANCE (Ω/□)

VALUE X IN WSix

# F I G. 8